# EUROPÄISCHE PATENTANMELDUNG

(11) **EP 1 067 685 A2**
(43) Veröffentlichungstag der Anmeldung: **10.01.2001**
(21) Anmeldenummer: 00202274.7
(22) Anmeldetag: 29.06.2000
(51) Int. Cl.: H03H 9/58

(54) **Volumenwellen-Filter**

(30) Priorität: 07.07.1999 DE 19931297
(71) Anmelder: Philips Corporate Intellectual Property GmbH, 52064 Aachen (DE); Koninklijke Philips Electronics N.V., 5621 BA Eindhoven (NL)
(72) Erfinder: Löbl, Hans-Peter, Philips Corp. Int. Prop. GmbH, 52064 Aachen (DE); Klee, Mareike, Philips Corp. Int. Prop. GmbH, 52064 Aachen (DE); Leyten, Lukas, Philips Corp. Int. Prop. GmbH, 52064 Aachen (DE)
(74) Vertreter: Volmer, Georg, Dipl.-Ing.

(57) **Zusammenfassung**

Die Erfindung beschreibt eine Filteranordnung sowie ein elektronisches Bauelement mit jeweils einer Volumenwellen-Resonatoreinheit, die sich auf einem Trägersubstrat (1) befindet. Zur akustischen Isolation der erzeugten Schwingungen wird zwischen Trägersubstrat (1) und Volumenwellen-Resonatoreinheit ein Reflexionselement (2) aufgebracht. Dieses Reflexionselement (2) kann entweder aus mehreren Schichten mit abwechselnd hoher und niedriger Impedanz oder bei ausreichend niedriger Impedanz des verwendeten Schallreflexionsstoffes aus einer einzigen Schicht bestehen.

Außerdem wird ein Mobilfunkgerät, ein Sender, ein Empfänger und ein drahtloses Datenübertragungssystem mit einer solchen Filteranordnung sowie ein Verfahren zur Herstellung eines elektronischen Bauelementes beschrieben.

## Beschreibung

Die Erfindung betrifft eine Filteranordnung mit einem Trägersubstrat, einer Resonatoreinheit und einem Reflexionselement zwischen Trägersubstrat und Resonatoreinheit. Die Erfindung betrifft auch ein elektronisches Bauelement mit einem Trägersubstrat, einer Resonatoreinheit und einem Reflexionselement zwischen Trägersubstrat und Resonatoreinheit, sowie ein Verfahren seiner Herstellung.

Die rasanten Entwicklungen im Mobilfunkbereich und die stete Miniaturisierung der schnurlosen Telefonapparate führen zu erhöhten Anforderungen an die einzelnen Komponenten. So ist eine hohe Selektivität im Hochfrequenzteil nötig, um den Empfänger gegen die steigende Anzahl möglicherweise störender Signale von anderen Systeme zu schützen.

Zur Zeit werden im Hochfrequenzbereich für diese Aufgabe Filter mit keramischen, elektromagnetischen Resonatoren verwendet. Einer Miniaturisierung dieser Filter wird aber durch die elektromagnetische Wellenlänge Grenzen gesetzt. Deutlich kleiner können Oberflächenwellen-Filter, sogenannte Surface Acoustic Wave (SAW) Filter, ausgeführt werden. Der Grund hierfür ist, daß die akustische Wellenlänge 4 bis 5 Größenordnungen kleiner ist als die elektromagnetische Wellenlänge. Nachteilig ist aber, daß Oberflächenwellen-Filter oftmals einen komplizierten Aufbau besitzen und mit Hilfe komplexer Gehäuse geschützt werden.

Eine Alternative stellen Volumenwellen-Filter, die auch als Bulk Acoustic Wave (BAW) Filter bezeichnet werden, dar. Volumenwellen-Filter besitzen Vorteile in den Bereichen Größe, Leistung und IC-Kompatibiität. Volumenwellen-Filter können mit unterschiedlichsten Typen an Volumenwellen-Resonatoren realisiert werden. So können zum Beispiel Einkristall-Resonatoren, Resonatoren mit Membranen oder Resonatoren mit einem Luftspalt verwendet werden.

Volumenwellen-Resonatoren sind prinzipiell aus drei Komponenten aufgebaut. Die erste Komponente generiert die akustische Welle und enthält eine piezoelektrische Schicht. Zwei Elektroden, welche ober- und unterhalb der piezoelektrischen Schicht angebracht sind, stellen die Zweite Komponente dar. Die dritte Komponente hat die Aufgabe das Trägersubstrat von den Schwingungen, die die piezoelektrische Schicht erzeugt, akustisch zu isolieren.

Eine Möglichkeit zur akustischen Isolation stellen Reflexionsschichten dar, die zwischen Trägersubstrat und Resonatoreinheit aufgebracht werden. Solche Reflexionsschichten bestehen aus Schichten mit abwechselnd hoher und niedriger akustischer Impedanz. Die Dicke der einzelnen Schichten beträgt ein Viertel der Resonanzwellenlänge. Diese Schichten haben den Zweck, die akustischen Wellen an den jeweiligen Grenzflächen möglichst gut zu reflektieren und somit die akustische Energie in der Resonatoreinheit zu halten. Die Anzahl der benötigten Schichten richtet sich einerseits nach den Unterschieden in der akustischen Impedanz der einzelnen Schichten und andererseits nach der Resonatorgüte Q, die erreicht werden soll.

Die einzelnen Reflexionsschichten können in den verschiedensten Materialien ausgeführt werden. Als Material mit niedriger akustischer Impedanz wird häufig SiO₂ mit einer akustischen Impedanz von 13 Ggm⁻²s⁻¹ verwendet. AlN mit einer akustischen Impedanz von 34 Ggm⁻²s⁻¹, W mit einer akustischen Impedanz von 101 Ggm⁻²s⁻¹ und HfO₂ mit einer akustischen Impedanz von 40 Ggm⁻²s⁻¹ werden als Materialien in Schichten mit hoher akustischer Impedanz verwendet.

Aus WO 98/16957 ist ein Volumenwellen-Resonator bekannt, bei dem in den Reflexionsschichten als Materialien mit niedriger akustischer Impedanz Polymere wie zum Beispiel Polyimid zum Einsatz kommen. Durch eine niedrige akustische Impedanz von 2 Ggm⁻²s⁻¹ kann die Anzahl der zur akustischen Isolation benötigten Reflexionsschichten verringert werden.

Der Erfindung liegt die Aufgabe zugrunde, einen verbesserten Volumenwellen-Filter bereitzustellen.

Diese Aufgabe wird gelöst, durch eine Filteranordnung mit einem Trägersubstrat, einer Resonatoreinheit und einem Reflexionselement zwischen Trägersubstrat und Resonatoreinheit, dadurch gekennzeichnet, daß das Reflexionselement eine Schicht aus einem Schallreflexionsstoff enthält.

Es ist bevorzugt, daß der Schallreflexionsstoff aus der Gruppe der polymeren und porösen Stoffe ist.

Poröse oder polymere Schallreflexionsstoffe besitzen geringe akustische Impedanzen und ermöglichen dadurch, daß nur eine Schicht zur Reflexion der gesamten akustischen Energie nötig ist. In diesem Fall kann sogar auf die Bedingung, daß die Dicke der Schicht ein Viertel der Resonanzwellenlänge beträgt, verzichtet werden. Dies vereinfacht den Aufbau und verbilligt die Herstellung der Filteranordnung.

Es ist besonders bevorzugt, daß der Schallreflexionsstoff ein Aerogel, ein Xerogel, ein Glasschaum, ein schaumartiger Klebstoff, ein Schaumstoff oder ein Kunststoff mit geringer Dichte ist.

Der Vorteil dieser Materialien ist, daß sie extrem geringe Impedanzen von bis zu 10⁻² Ggm⁻²s⁻¹, je nach verwendetem Material, besitzen. Die akustische Impedanz liegt damit im günstigsten Fall nur zwei Größenordnungen über der akustischen Impedanz von Luft (4 · 10⁻⁴ Ggm⁻²s⁻¹).

Es kann bevorzugt sein, daß das Reflexionselement Schichten mit abwechselnd hoher und niedriger Impedanz und als Material für eine Schicht mit niedriger Impedanz einen Schallreflexionsstoff aufweist.

Durch die geringen akustischen Impedanzen von polymeren und porösen Schallreflexionsstoffen sind nur sehr wenige Schichten im Reflexionselement nötig, um die gesamte akustische Energie zu reflektieren.

Es ist bevorzugt, daß das Material mit hoher Impedanz HfO₂, Mo, Au, Ni, Cu, W, Ti/W/Ti, WₓTi₁₋ₓ(0 ≤ x ≤ 1), Diamant, Ta₂O₅, Pt, Ti/Pt oder einen Kunststoff mit hoher Dichte enthält.

Die Materialien können mit Dünnschichtverfahren wie reaktivem Sputtern oder Vakuum-Aufdampfverfahren wie zum Beispiel Chemical Vapour Deposition (CVD), Physical Chemical Vapour Deposition (PCVD) oder Spin Coating aufgebracht werden.

In dieser Filteranordnung ist es außerdem bevorzugt, daß die Dicke der Schichten jeweils ein Viertel der Resonanzwellenlänge ist.

In einer Abfolge von Schichten mit abwechselnd hoher und niedriger Impedanz sowie bei einer Schichtdicke von einem Viertel der Resonanzwellenlänge kombinieren die Reflexionen jeder Schicht bei der Resonanzwellenlänge in Phase.

Es kann bevorzugt sein, daß ein weiteres Reflexionselement auf der Resonatoreinheit angeordnet ist.

Das Aufbringen eines weiteren Reflexionselementes auf der Resonatoreinheit hat einerseits den Vorteil, daß keine akustischen Schwingungen an die obere Seite der Filteranordnung gelangen. Andererseits schützen die Reflexionselemente die Resonatoreinheit vor Kontaminierung mit Staubpartikeln oder ähnlichem. Das Aufbringen von Reflexionselementen ober- und unterhalb der Resonatoreinheit, die im günstigsten Fall nur aus einer Schicht bestehen, ist preiswerter als andere Schutztechniken wie beispielsweise eine halbhermetische Packung.

Es ist auch bevorzugt, daß über der Filteranordnung eine Schutzschicht aus einem organischen und/oder anorganischen Material ist.

Durch die Schutzschicht wird die Filteranordnung vor mechanischer Beanspruchung und Korrosion durch Feuchtigkeit geschützt.

Es ist bevorzugt, daß das Trägersubstrat ein keramisches Material, ein keramisches Material mit einer Planarisierungsschicht aus Glas, ein glaskeramisches Material, ein Glasmaterial, Silicium, GaAs oder Saphir enthält.

Ein Trägersubstrat aus einem keramischen Material, einem keramischen Material mit einer Planarisierungsschicht aus Glas, einem glaskeramischen Material oder einem Glasmaterial ist kostengünstig herzustellen und die Prozeßkosten für diese Komponente können niedrig gehalten werden. Bei Integration der Filteranordnung in IC's ist das Trägersubstrat aus einem halbleitenden Material gegebenenfalls noch mit einer Passivierungsschicht, beispielsweise SiO₂ oder aus Glas, versehen.

Weiterhin ist es bevorzugt, daß die Resonatoreinheit eine piezoelektrische Schicht aus PbZr_{0.15}Ti_{0.85}O₃ mit einer 2%igen Lanthan-Dotierung enthält.

PbZr_{0.15}Ti_{0.85}O₃ mit einer 2%igen Lanthan-Dotierung weist besonders gute piezoelektrische Eigenschaften in der Filteranordnung auf.

Es kann bevorzugt sein, daß zwischen Trägersubstrat und Reflexionselement eine Klebstoffschicht ist.

Diese Schicht dient der Befestigung des Reflexionselementes auf dem Trägersubstrat.

Außerdem betrifft die Erfindung Mobilfunkgerät, einen Sender, einen Empfänger und ein drahtloses Datenübertragungssystem ausgerüstet mit einer Filteranordnung mit einem Trägersubstrat, einer Resonatoreinheit und einem Reflexionselement zwischen Trägersubstrat und Resonatoreinheit, bei der das Reflexionselement eine Schicht aus einem Schallreflexionsstoff enthält.

Die Erfindung betrifft auch ein elektronisches Bauelement mit einem Trägersubstrat, einer Resonatoreinheit und einem Reflexionselement zwischen Trägersubstrat und Resonatoreinheit, bei dem das Reflexionselement eine Schicht aus einem Schallreflexionsstoff enthält.

Bei Verwendung von polymeren und porösen Schallreflexionsstoffen mit extrem niedrigen Impedanzen als Reflexionselement können preiswerte Bauelemente, wie zum Beispiel Volumenwellen-Resonatoren, hergestellt werden. Eine Reduktion der Produktionskosten ergibt sich einmal dadurch, daß nur eine Schicht für das Reflexionselement aufgebracht werden muß und außerdem dadurch, daß diese nicht notwendigerweise eine Schichtdicke von einem Viertel der Resonanzwellenlänge aufweisen muß.

Weiterhin betrifft die Erfindung ein Verfahren zur Herstellung eines elektronischen Bauelementes mit einem Trägersubstrat, einer Resonatoreinheit und einem Reflexionselement aus einem Schallreflexionsstoff, bei dem
- auf einer Substratschicht eine Resonatoreinheit aufgebracht wird,
- auf der Resonatoreinheit ein Reflexionselement aus einem Schallreflexionsstoff aufgebracht wird,
- auf dem Reflexionselement ein Trägersubstrat befestigt wird und die Substratschicht entfernt wird.

Im folgenden soll die Erfindung anhand von vier Figuren und acht Ausführungsbeispielen erläutert werden. Dabei zeigt
- Fig. 1: im Querschnitt den Aufbau einer Ausführungsform einer Volumenwellen-Filteranordnung,
- Fig. 2: die Schaltungsanordnung einer Volumenwellen-Filteranordnung,
- Fig. 3: im Querschnitt einen Volumenwellen-Resonator mit zwei Reflexionselementen und
- Fig. 4: ein Fließschema zur Herstellung eines Volumenwellen-Resonators.

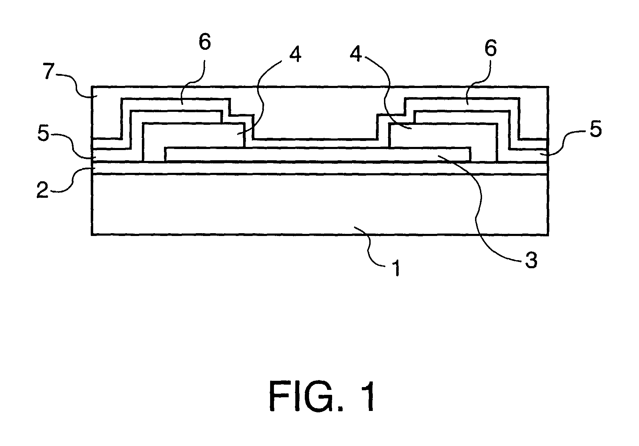

Gemäß Fig. 1 weist eine Volumenwellen-Filteranordnung ein Trägersubstrat 1 auf, welches zum Beispiel aus einem keramischen Material, einem keramischen Material mit einer Planarisierungsschicht aus Glas, einem glaskeramischen Material, einem Glasmaterial, Silicium, GaAs oder Saphir ist. Bei Verwendung von Silicium oder GaAs als Trägersubstrat 1 wird noch eine Passivierungsschicht aus beispielsweise SiO₂ oder Glas aufgebracht. Auf dem Trägersubstrat 1 befindet sich ein erstes Reflexionselement 2, welches eine Schicht eines Schallreflexionsstoffes aus der Gruppe der polymeren und porösen Stoffe ist. Als Schallreflexionsstoff kann beispielsweise ein Aerogel, ein Xerogel, ein Glasschaum, ein schaumartiger Klebstoff, ein Schaumstoff oder ein Kunststoff mit geringer Dichte eingesetzt werden. Als Aerogel kann zum Beispiel ein anorganisches Aerogel aus Kieselgel oder porösen SiO₂-Strukturen oder ein organisches Aerogel wie zum Beispiel ein Resorcin-Formaldehyd-Aerogel, ein Melamin-Formaldehyd-Aerogel oder ein Phenol-Formaldehyd-Aerogel verwendet werden. Als Xerogel kann beispielsweise ein anorganisches Xerogel wie hochkondensierte Polykieselsäure oder ein organisches Xerogel wie Leim oder Agar-Agar eingesetzt werden. Als Schaumstoffe können chemisch aufgeschäumte oder physikalisch aufgeschäumte Polymere wie zum Beispiel Polystyrol, Polycarbonate, Polyvinylchlorid, Polyurethane, Polyisocyanate, Polyisocyanurate, Polycarbodiimide, Polymethacrylimide, Polyacrylimide, Acryl-Butadien-Styrol-Copolymere, Polypropylene oder Polyester eingesetzt werden. Außerdem können auch geschäumte Kunstharze wie beispielsweise Phenol-Formaldehyd-Harze oder Furanharze, die durch Verkokung eine hohe Porosität besitzen, verwendet werden. Als Kunststoff mit geringer Dichte kann zum Beispiel ein vernetzter Polyvinylether, ein vernetzter Polyarylether, Polytetrafluorethylen, Poly(*p*-xylylen), Poly(2-chlor-*p*-xylylen), Poly(dichlor-*p*-xylylen), Polybenzocyclobuten, ein Styrol-Butadien-Copolymer, ein Ethylen-Vinylacetat-Polymer oder ein organisches Siloxanpolymer Verwendung finden. Auf dem ersten Reflexionselement 2 sind zwei Resonatoreinheiten aufgebracht, welche jeweils eine erste Elektrode 3, eine piezoelektrische Schicht 4 und eine zweite Elektrode 5 enthalten. Die Elektroden 3 und 5 sind vorzugsweise aus einem gut leitendem Material mit geringer akustischer Dämpfung und können beispielsweise Ag₁₋ₓPtₓ (0 ≤ x ≤ 1), Pt (50 nm bis 1 µm), Ti (1 bis 20 nm)/Pt (20 bis 600 nm), Ti (1 bis 20 nm)/Pt (20 bis 600 nm)/Ti (1 bis 20 nm), Al, Al dotiert mit einigen Prozent Cu, Al dotiert mit einigen Prozent Si, Al dotiert mit einigen Prozent Mg, W, Ni, Mo, Au, Cu, Ti/Pt/Al, Ti/Ag, Ti/Ag/Ti, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Rh, Rh/RhO₂, Ti/Ag/Pt_{y}(RhOₓ)_{1-y}/Pt_{z}Rh_{1-z} (0 ≤ x ≤ 2, 0 ≤ y ≤ 1, 0 ≤ z ≤ 1), Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, Ti/Ni, Ti/W/Ti, WₓTi₁₋ₓ (0 ≤ x ≤ 1), WₓTi₁₋ₓ/Al(Cu) (0 ≤ x ≤ 1), WₓTi₁₋ₓ/Al(Si) (0 ≤ x ≤ 1), WₓTi₁₋ₓ/Al (0 ≤ x ≤ 1) oder Ti/Cu enthalten. Als Material für die piezoelektrische Schicht 4 kann zum Beispiel AlN, ZnO, PbTi₁₋ₓZrₓO₃ (O ≤ x ≤ 1) mit und ohne Dotierungen aus La oder Mn, LiNbO₃, LiTaO₃, PbNb₂O₆ oder Polyvinylidenfluorid (PVDF) verwendet werden. Auf Teilen der ersten Elektrode 3 und zweiten Elektrode 5 sowie der piezoelektrischen Schicht 4 wird ein zweites Reflexionselement 6, welches beispielsweise eine Schicht aus einem Aerogel, einem Xerogel, einem Glasschaum, einem schaumartigen Klebstoff, einem Schaumstoff oder einem Kunststoff mit geringer Dichte ist, aufgebracht. Alternativen im Aufbau sind dem Fachmann wohlbekannt. Über der gesamten Filteranordnung wird eine Schutzschicht 7 aus einem organischen und/oder anorganischen Material aufgebracht. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden.

Alternativ können die Reflexionselemente 2 und 6 aus mehreren Schichten mit abwechselnd hoher und niedriger Impedanz bestehen. Dabei kann das Material mit niedriger Impedanz zum Beispiel ein organisches oder anorganisches Aerogel, ein organisches oder anorganisches Xerogel, ein Glasschaum, ein schaumartiger Klebstoff, ein Schaumstoff oder ein Kunststoff mit geringer Dichte sein. Als Material mit hoher akustischer Impedanz kann beispielsweise HfO₂, Mo, Au, Ni, Cu, W, Ti/W/Ti, WₓTi₁₋ₓ (0 ≤ x ≤ 1), Diamant, Ta₂O₅, Pt, Ti/Pt oder ein Kunststoff mit hoher Dichte wie beispielsweise High-Density-Polyethylen (HDPE) verwendet werden.

Ferner kann als weitere Ausführungsform der Erfindung das zweite Reflexionselement 6 und/oder die Schutzschicht 7 weggelassen werden.

Eine weitere Alternative ist, daß zwischen Reflexionselement 2 und dem Trägersubstrat 1 eine zusätzliche Klebstoffschicht beispielsweise aus einem Acrylat-Klebstoff oder einem Epoxid-Klebstoff aufgebracht ist. Der Acrylat-Klebstoff kann beispielsweise Acryl- oder Methacryl-Monomere enthalten, die während des Verklebungsprozeß polymerisieren.

Weiterhin kann ober- und/oder unterhalb eines Reflexionselementes 2 aus porösem SiO₂ eine Schicht aus SiO₂ mit einer Schichtdicke zwischen 30 und 300 nm aufgebracht sein.

Außerdem kann die Filteranordnung mit wenigstens einer ersten und einer zweiten Stromzuführung versehen werden. Als Stromzuführung kann beispielsweise ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktflache eingesetzt werden.

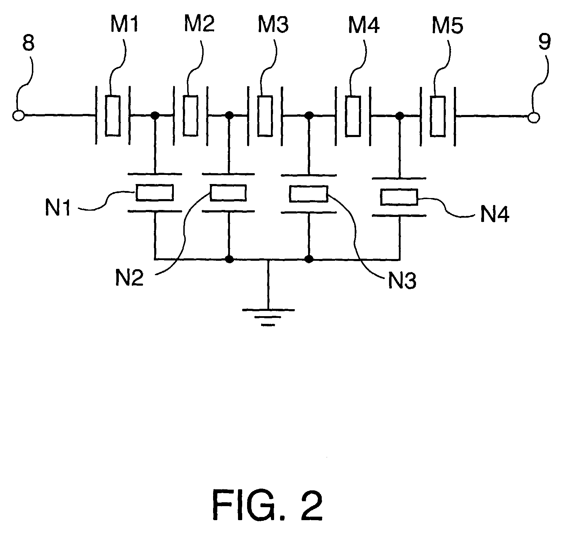

Fig. 2 zeigt eine Filteranordnung aus insgesamt neun Resonatoreinheiten M1 bis M5 sowie N1 bis N4. Zwischen einem Eingang 8 und einem Ausgang 9 sind fünf Resonatoreinheiten M1 bis M5 in Serie geschalten. Vier weitere Resonatoreinheiten N1 bis N4 sind parallel zu diesen fünf Resonatoreinheiten M1 bis M5 geschalten. Jeweils ein Anschluß der vier Resonatoreinheiten N1 bis N4 liegt auf Erdpotential. Der andere Anschluß der Resonatoreinheit N1 liegt zwischen den Resonatoreinheiten M1 und M2. Der andere Anschluß der Resonatoreinheit N2 liegt zwischen den Resonatoreinheiten M2 und M3. Der andere Anschluß der Resonatoreinheit N3 liegt zwischen den Resonatoreinheiten M3 und M4. Und der andere Anschluß der Resonatoreinheit N4 liegt zwischen den Resonatoreinheiten M4 und M5.

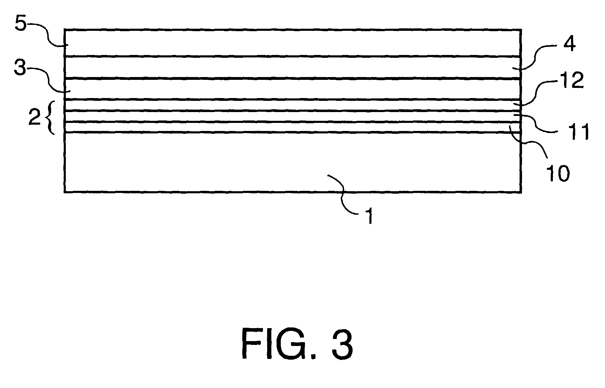

Gemäß Fig. 3 weist ein elektronisches Bauelement ein Trägersubstrat 1 auf, welches zum Beispiel aus einem keramischen Material, einem keramischen Material mit einer Planarisierungsschicht aus Glas, einem glaskeramischen Material, einem Silicium, GaAs oder Saphir ist. Bei Verwendung von Silicium oder GaAs als Trägersubstrat 1 wird noch eine Passivierungsschicht aus beispielsweise SiO₂ oder Glas aufgebracht. Auf dem Trägersubstrat 1 ist ein Reflexionselement 2 mit mehreren Schichten, einer unteren Schicht 10, einer mittleren Schicht 11 und einer oberen Schicht 12, aufgebracht. Die einzelnen Schichten weisen eine Schichtdicke von einem Viertel der Resonanzwellenlänge auf. Die untere Schicht 10 und die obere Schicht 12 sind aus einem Material mit niedriger akustischer Impedanz und enthalten einen Schallreflexionsstoff aus der Gruppe der polymeren und porösen Stoffe. Als Schallreflexionsstoff kann beispielsweise ein Aerogel, ein Xerogel, ein Glasschaum, ein schaumartiger Klebstoff, ein Schaumstoff oder ein Kunststoff mit geringer Dichte eingesetzt werden. Als Aerogel kann zum Beispiel ein anorganisches Aerogel aus Kieselgel oder porösen SiO₂-Strukturen oder ein organisches Aerogel wie zum Beispiel ein Resorcin-Formaldehyd-Aerogel, ein Melamin-Formaldehyd-Aerogel oder ein Phenol-Formaldehyd-Aerogel verwendet werden. Als Xerogel kann beispielsweise ein anorganisches Xerogel wie hochkondensierte Polykieselsäure oder ein organisches Xerogel wie Leim oder Agar-Agar eingesetzt werden. Als Schaumstoffe können chemisch aufgeschäumte oder physikalisch aufgeschäumte Polymere wie zum Beispiel Polystyrol, Polycarbonate, Polyvinylchlorid, Polyurethane, Polyisocyanate, Polyisocyanurate, Polycarbodiimide, Polymethacrylimide, Polyacrylimide, Acryl-Butadien-Styrol-Copolymere, Polypropylene oder Polyester eingesetzt werden. Außerdem können auch geschäumte Kunstharze wie beispielsweise Phenol-Formaldehyd-Harze oder Furanharze, die durch Verkokung eine hohe Porosität besitzen, verwendet werden. Als Kunststoff mit geringer Dichte kann zum Beispiel ein vernetzter Polyvinylether, ein vernetzter Polyarylether, Polytetrafluorethylen, Poly(*p*-xylylen), Poly(2-chlor-*p*-xylylen), Poly(dichlor-*p*-xylylen), Polybenzocyclobuten, ein Styrol-Butadien-Copolymer, ein Ethylen-Vinylacetat-Polymer oder ein organisches Polysiloxanpolymer Verwendung finden. Die akustische Impedanz der mittleren Schicht 11 ist höher als die akustische Impedanzen der unteren Schicht 10 und der oberen Schicht 12. Die mittlere Schicht 11 ist aus einem Material mit hoher akustischer Impedanz wie zum Beispiel HfO₂, Mo, Au, Ni, Cu, W, Ti/W/Ti, WₓTi₁₋ₓ, Diamant, Ta₂O₅, Pt, Ti/Pt oder einem Kunststoff mit hoher Dichte wie zum Beispiel High-Density-Polyethylen (HDPE). Auf der oberen Schicht 12 sind eine erste Elektrode 3, eine piezoelektrische Schicht 4 und eine zweite Elektrode 5 aufgebracht. Die Elektroden 3 und 5 sind vorzugsweise aus einem gut leitenden Material mit geringer akustischer Dämpfung und können beispielsweise Ag₁₋ₓPtₓ (0 ≤ x ≤ 1), Pt
(50 nm bis 1 µm), Ti (1 bis 20 nm)/Pt (20 bis 600 nm), Ti (1 bis 20 nm)/Pt (20 bis 600 nm)/Ti (1 bis 20 nm), Al, Al dotiert mit einigen Prozent Cu, Al dotiert mit einigen Prozent Si, Al dotiert mit einigen Prozent Mg, Ni, W, Mo, Au, Cu, Ti/Pt/Al, Ti/Ag, Ti/Ag/Ti, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1),Ti/Ag/Pt_{y}(RhOₓ)_{1-y} (0 ≤ x ≤ 2, 0 ≤ y ≤ 1),Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2, 0 ≤ y ≤ 1, 0 ≤ z ≤ 1), Rh, Rh/RhO₂, Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, Ti/Ni, Ti/W/Ti, WₓTi₁₋ₓ (0 ≤ x ≤ 1), WₓTi₁₋ₓ/Al(Cu) (0 ≤ x ≤ 1), WₓTi₁₋ₓ/Al(Si) (0 ≤ x ≤ 1), WₓTi₁₋ₓ/Al (0 ≤ x ≤ 1) oder Ti/Cu enthalten. Als Material für die piezoelektrische Schicht 4 kann zum Beispiel AlN, ZnO, PbTi₁₋ₓZrₓO₃ (0 ≤ x ≤ 1) mit und ohne Dotierungen aus La oder Mn, LiNbO₃, LiTaO₃, PbNb₂O₆, Pb₁₋ₓCaₓTiO₃ (0 ≤ x ≤ 1), [Pb(Mg_{1/3}Nb_{2/3})O₃]-PbTiO₃]₁₋ₓ (0 ≤ x ≤ 1), BaTiO₃, K₁₋ₓNaₓNbO₃ (0 ≤ x ≤ 1), (Cd,Na)NbO₃, (Bi,Na)TiO₃, (Bi,Na,Pb,Ba)TiO₃, Bi₇Ti₄NbO₂₁, (Ba₁₋ₓSrₓ)₂NaNb₅O₁₅ (0 ≤ x ≤ 1), (Ba₁₋ₓSrₓ)₂KNb₅O₁₅ (0 ≤ x ≤ 1),
a) Pb(Mg_{1/2}W_{1/2})O₃,
b) Pb(Fe_{1/2}Nb_{1/2})O₃,
c) Pb(Fe_{2/3}W_{1/3})O₃,
d) Pb(Ni_{1/3}Nb_{2/3})O₃,
e) Pb(Zn_{1/3}Nb_{2/3})O₃,
f) Pb(Sc_{1/2}Ta_{1/2})O₃, Kombinationen der Verbindungen a) bis f) mit PbTiO₃ und Pb(Mg_{1/3}Nb_{2/3})O₃ mit und ohne Bleiüberschuss oder Polyvinylidenfluorid (PVDF) verwendet werden.

Alternativ kann auf der zweiten Elektrode 5 ein weiteres Reflexionselement 6 aufgebracht werden, das entweder eine Schicht aus einem Material extrem niedriger akustischer Impedanz oder mehrere Schichten mit abwechselnd hoher und niedriger Impedanz aufweist.

Es ist auch möglich, daß das Reflexionselement 2 nur eine Schicht, die nicht notwendigerweise eine Schichtdicke von einem Viertel der Resonanzwellenlänge aufweist, oder mehr als drei Schichten enthält.

Ferner kann ober- und unterhalb eines Reflexionselementes 2 aus porösem SiO₂ eine Schicht aus SiO₂ mit einer Schichtdicke zwischen 30 und 300 nm aufgebracht sein.

Weiterhin kann über dem gesamten Bauelement eine Schutzschicht aus einem organischen und/oder anorganischen Material aufgebracht werden. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden.

In einer weiteren Alternative ist zwischen Reflexionselement 2 und dem Trägersubstrat 1 eine zusätzliche Klebstoffschicht, bespielsweise aus einem Acrylat-Klebstoff oder einem Epoxid-Klebstoff, aufgebracht. Der Acrylat-Klebstoff kann beispielsweise Acryl- oder Methacryl-Monomere enthalten, die während des Verklebungsprozeß polymerisieren.

Auf gegenüberliegenden Seiten des elektronischen Bauelementes kann wenigstens eine erste und eine zweite Stromzuführung angebracht werden. Als Stromzuführung kann beispielsweise ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktfläche eingesetzt werden.

Als Bauelement kann beispielsweise ein Volumenwellen-Resonator hergestellt werden. Mehrere dieser Volumenwellen-Resonatoren können zu einer Volumenwellen-Filteranordnung verschaltet werden.

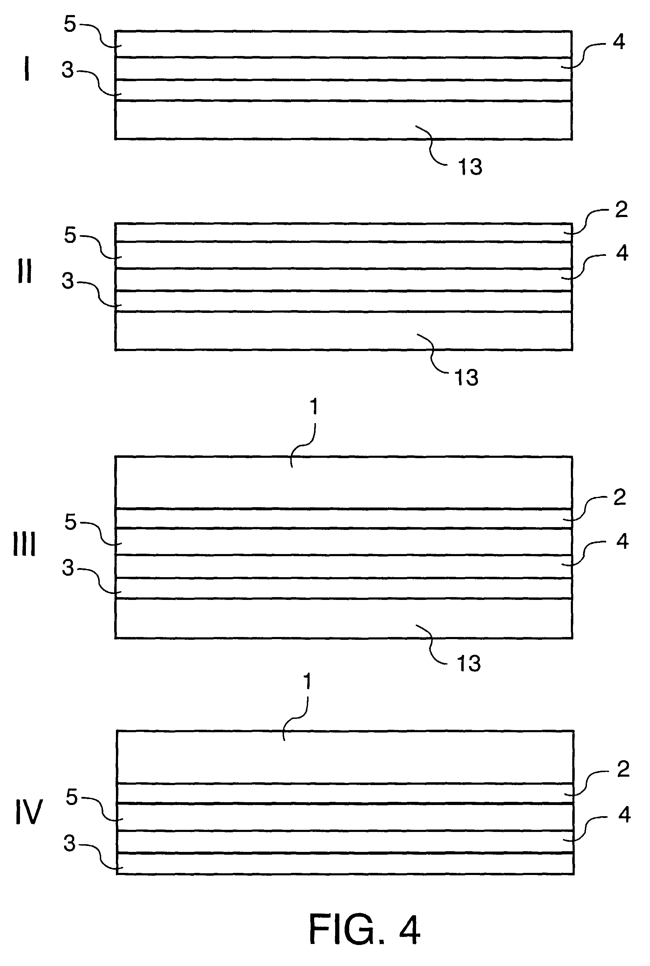

Gemäß Fig. 4 ist eine Möglichkeit ein erfindungsgemäßes elektronisches Bauelement herzustellen, indem im ersten Schritt auf einer Substratschicht 13 eine Resonatoreinheit, welche eine erste Elektrode 3, eine piezoelektrische Schicht 4 und eine zweite Elektrode 5 enthält, abgeschieden wird (Verfahrensschritt 1 in Fig. 4). Die Substratschicht 13 kann zum Beispiel aus einem keramischen Material, einem keramischen Material mit einer Planarisierungsschicht aus Glas, einem glaskeramischen Material, einem Silicium, GaAs oder Saphir sein. Bei Verwendung von Silicium oder GaAs in der Substratschicht 13 wird noch eine Passivierungsschicht aus beispielsweise SiO₂ oder Glas aufgebracht. Die Elektroden 3 und 5 sind vorzugsweise aus einem gut leitenden Material mit geringer akustischer Dämpfung und können beispielsweise Ag₁₋ₓPtₓ (0 ≤ x ≤ 1), Pt
(50 nm bis 1 µm), Ti (1 bis 20 nm)/Pt (20 bis 600 nm), Ti (1 bis 20 nm)/Pt (20 bis 600 nm)/Ti (1 bis 20 nm), Al, Al dotiert mit einigen Prozent Cu, Al dotiert mit einigen Prozent Si, Al dotiert mit einigen Prozent Mg, Ni, W, Mo, Au, Cu, Ti/Pt/Al, Ti/Ag, Ti/Ag/Ti, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁-ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1),Ti/Ag/Pt_{y}(RhOₓ)_{1-y} (0 ≤ x ≤ 2, 0 ≤ y ≤ 1),Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2, 0 ≤ y ≤ 1, 0 ≤ z ≤ 1), Rh, Rh/RhO₂, Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, TI/Ni, Ti/W/Ti, WₓTi₁₋ₓ (0 ≤ x ≤ 1), WₓTi₁₋ₓ/Al(Cu) (0 ≤ x ≤ 1), WₓTi₁₋ₓ/Al(Si) (0 ≤ x ≤ 1), WₓTi₁₋ₓ/Al (0 ≤ x ≤ 1) oder Ti/Cu enthalten. Als Material für die piezoelektrische Schicht 4 kann zum Beispiel AlN, ZnO, PbTi₁₋ₓZrₓO₃ (0 ≤ x ≤ 1) mit und ohne Dotierungen aus La oder Mn, LiNbO₃, LiTaO₃, PbNb₂O₆, Pb₁₋ₓCaₓTiO₃ (0 ≤ x ≤ 1), [Pb(Mg_{1/3}Nb_{2/3})O₃]-PbTiO₃]₁₋ₓ (0 ≤ x ≤ 1), BaTiO₃, K₁₋ₓNaₓNbO₃ (0 ≤ x ≤ 1), (Cd,Na)NbO₃, (Bi,Na)TiO₃, (Bi,Na,Pb,Ba)TiO₃, Bi₇Ti₄NbO₂₁, (Ba₁₋ₓSrₓ)₂NaNb₅O₁₅ (0 ≤ x ≤ 1), (Ba₁₋ₓSrₓ)₂KNb₅O₁₅ (0 ≤ x ≤ 1),
a) Pb(Mg_{1/2}W_{1/2})O₃,
b) Pb(Fe_{1/2}Nb_{1/2})O₃,
c) Pb(Fe_{2/3}W_{1/3})O₃,
d) Pb(Ni_{1/3}Nb_{2/3})O₃,
e) Pb(Zn_{1/3}Nb_{2/3})O₃,
f) Pb(Sc_{1/2}Ta_{1/2})O₃, Kombinationen der Verbindungen a) bis f) mit PbTiO₃ und Pb(Mg_{1/3}Nb_{2/3})O₃ mit und ohne Bleiüberschuss oder Polyvinylidenfluorid (PVDF) verwendet werden. Auf der zweiten Elektrode 5 wird ein Reflexionselement 2 aus einem Schallreflexionsstoff der Gruppe der polymeren und porösen Stoffe aufgebracht (Verfahrensschritt II in Fig. 4). Als Schallreflexionsstoff kann beispielsweise ein Aerogel, ein Xerogel, ein Glasschaum, ein schaumartiger Klebstoff, ein Schaumstoff oder ein Kunststoff mit geringer Dichte eingesetzt werden. Als Aerogel kann zum Beispiel ein anorganisches Aerogel aus Kieselgel oder porösen SiO₂-Strukturen oder ein organisches Aerogel wie zum Beispiel ein Resorcin-Formaldehyd-Aerogel, ein Melamin-Formaldehyd-Aerogel oder ein Phenol-Formaldehyd-Aerogel verwendet werden. Als Xerogel kann beispielsweise ein anorganisches Xerogel wie hochkondensierte Polykieselsäure oder ein organisches Xerogel wie Leim oder Agar-Agar eingesetzt werden. Als Schaumstoffe können chemisch aufgeschäumte oder physikalisch aufgeschäumte Polymere wie zum Beispiel Polystyrol, Polycarbonate, Polyvinylchlorid, Polyurethane, Polyisocyanate, Polyisocyanurate, Polycarbodimide, Polymethacrylimide, Polyacrylimide, Acryl-Butadien-Styrol-Copolymere, Polypropylene oder Polyester eingesetzt werden. Außerdem können auch geschäumte Kunstharze wie beispielsweise Phenol-Formaldehyd-Harze oder Furanharze, die durch Verkokung eine hohe Porosität besitzen verwendet werden. Als Kunststoff mit geringer Dichte können zum Beispiel vernetzte Polyvinylether, vernetzte Polyarylether, Polytetrafluorethylen, Poly(*p*-xylylen), Poly(2-chlor-*p*-xylylen), Poly(dichlor-*p*-xylylen), Polybenzocyclobuten, Styrol-Butadien-Copolymere, Ethylen-Vinylacetat-Polymere oder organische Siloxanpolymere Verwendung finden. Auf diesem Reflexionselement 2 wird aufgrund der adhäsiven Eigenschaften des verwendeten Materials oder mittels einer zusätzlichen Klebstoffschicht, aus zum Beispiel einem Acrylat-Klebstoff oder einem Epoxid-Klebstoff, ein Trägersubstrat 1, welches aus Glas, einem glaskeramischen Material, glaskeramischen Material mit einer Planarisierungsschicht aus Glas, einem Glasmaterial Silicium, GaAs oder Saphir ist, befestigt (Verfahrensschritt III in Fig. 4). Bei Verwendung von Silicium oder GaAs als Trägersubstrat 1 wird noch eine Passivierungsschicht, beispielsweise aus SiO₂ oder Glas, aufgebracht. Anschließend wird das Substrat 13 mechanisch oder chemisch entfernt (Verfahrensschritt IV in Fig. 4).

Bei Verwendung von PbTi₁₋ₓZrₓO₃ (0 ≤ x ≤ 1) mit und ohne Dotierungen aus La oder Mn als Material für die piezoelektrische Schicht 4 kann zwischen Substratschicht 13 und erster Elektrode 3 eine Antireaktionsschicht aus TiO₂, Al₂O₃ oder ZrO₂ aufgebracht werden.

In einem alternativen Verfahren zur Herstellung eines erfindungsgemäßen elektronischen Bauelementes wird das Reflexionselement 2 direkt auf das gewünschte Trägersubstrat 1 abgeschieden. Anschließend wird die Resonatoreinheit aus erster Elektrode 3 und zweiter Elektrode 5 sowie der piezoelektrischen Schicht 4 aufgebracht. Das Reflexionselement 2 kann alternativ auch mehrere Schichten mit abwechselnd hoher und niedriger Impedanz enthalten.

In allen Fällen kann über dem gesamten Bauelement eine Schutzschicht 7 aus einem organischen und/oder anorganischen Material aufgebracht werden. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden.

Alternativ kann unter- und oberhalb der Resonatoreinheit des Bauelementes ein Reflexionselement angebracht werden. Das weitere Reflexionsekment 6 weist entweder eine Schicht aus einem Material extrem niedriger akustischer Impedanz oder mehrere Schichten mit abwechselnd hoher und niedriger Impedanz auf.

Weiterhin kann ober- und/oder unterhalb eines Reflexionselementes 2 bzw. 6 aus porösem SiO₂ eine Schicht aus SiO₂ mit einer Schichtdicke zwischen 30 und 300 nm aufgebracht sein.

Auf gegenüberliegenden Seiten des elektronischen Bauelementes kann wenigstens eine erste und eine zweite Stromzuführung angebracht werden. Als Stromzuführung kann beispielsweise ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktfläche eingesetzt werden.

Im folgenden werden Ausführungsformen der Erfindung erläutert, die beispielhafte Realisierungsmöglichkeiten darstellen.

### Ausführungsbeispiel 1

Auf einem Trägersubstrat 1 aus Glas wurde zunächst eine Klebstoffschicht aus Acrylat-Klebstoff und darauf als Reflexionselement 2 eine Schicht aus porösem SiO₂ abgeschieden. Auf einem bestimmten Teil des Reflexionselementes 2 wurde eine erste Elektrode 3 aus Pt abgeschieden. Eine piezoelektrische Schicht 4 aus AlN wurde auf bestimmte Teile der ersten Elektrode 3 und des Reflexionselements 2 aufgebracht. Eine zweite Elektrode 5 aus Al wurde auf bestimmte Teile der piezoelektrischen Schicht 4 und des Reflexionselements 2 abgeschieden. Die piezoelektrische Schicht 4 und die zwei Elektroden 3, 5 wurden derart abgeschieden und strukturiert, daß eine Filteranordnung gemäß Fig. 2 mit insgesamt 9 Resonatoreinheiten M1 bis M5 sowie N1 bis N4 enstand. Dabei wurden fünf Resonatoreinheiten M1 bis M5 in Serie geschalten und die vier weiteren Resonatoreinheiten N1 bis N4 wurden parallel zu diesen fünf Resonatoreinheiten M1 bis M5 geschalten. Jeweils ein Anschluß der vier Resonatoreinheiten N1 bis N4 lag auf Erdpotential, während die anderen Anschlüsse der Resonatoreinheiten N1 bis N4 jeweils zwischen zwei der fünf Resonatoreinheiten M1 bis M5 lagen. Ober der gesamten Filteranordnung wurde eine Schutzschicht 7 aus SiO₂ aufgebracht. Durch die Schutzschicht 7 wurden mittels Ätzens Kontaktlöcher zur zweiten Elektrode 5 geöffnet. In den Kontaktlöchern wurden Bump-end-Kontakte aus Cr/Cu aufgewachsen. Die erhaltene Filteranordnung wurde als Bandpassfilter in Mobiltelefonen eingesetzt.

### Ausführungsbeispiel 2

Zur Realisierung einer Filteranordnung mit einem Reflexionselement 2 aus mehreren Schichten wurde auf einem Trägersubstrat 1 aus Glas zunächst eine Klebstoffschicht aus Acrylat-Klebstoff und darauf eine untere Schicht 10 aus porösem SiO₂ abgeschieden. Auf diese Schicht wurde eine mittlere Schicht 11 aus Ta₂O₅ abgeschieden. Eine obere Schicht 12 aus porösem SiO₂ wurde anschließend auf die mittlere Schicht 11 aufgebracht. Auf bestimmte Teile der oberen Schicht 12 wurde eine erste Elektrode 3 aus Mo abgeschieden. Eine piezoelektrische Schicht 4 aus AlN wurde auf bestimmte Teile der ersten Elektrode 3 und der oberen Schicht 12 aufgebracht. Eine zweite Elektrode 5 aus Al wurde auf bestimmte Teile der piezoelektrischen Schicht 4 und der oberen Schicht 12 abgeschieden. Die piezoelektrische Schicht 4 und die zwei Elektroden 3, 5 wurden derart abgeschieden und strukturiert, daß eine Filteranordnung gemäß Fig. 2 mit insgesamt 9 Resonatoreinheiten M1 bis M5 sowie N1 bis N4 enstand. Dabei wurden fünf Resonatoreinheiten M1 bis M5 in Serie geschalten und die vier weitere Resonatoreinheiten N1 bis N4 wurden parallel zu diesen fünf Resonatoreinheiten M1 bis M5 geschalten. Jeweils ein Anschluß der vier Resonatoreinheiten N1 bis N4 lag auf Erdpotential, während die anderen Anschlüsse der Resonatoreinheiten N1 bis N4 jeweils zwischen zwei der fünf Resonatoreinheiten M1 bis M5 lagen. Ober die gesamte Filteranordnung wurde eine Schutzschicht 7 aus SiO₂ aufgebracht. Durch die Schutzschicht 7 wurden mittels Ätzens Kontaktlöcher zur zweiten Elektrode 5 geöffnet. In den Kontaktlöchern wurden Bump-end-Kontakte aus Cr/Cu aufgewachsen. Die erhaltene Filteranordnung wurde als Bandpassfilter in Mobiltelefonen eingesetzt.

### Ausführungsbeispiel 3

Zur Realisierung eines elektronischen Bauelementes mit einem Reflexionselement 2 aus mehreren Schichten wurde auf einem Trägersubstrat 1 aus Glas zunächst eine Klebstoffschicht aus Acrylat-Klebstoff und darauf eine untere Schicht 10 aus porösem SiO₂ abgeschieden. Auf diese Schicht wurde eine mittlere Schicht 11 aus Ta₂O₅ abgeschieden. Eine obere Schicht 12 aus porösem SiO₂ wurde anschließend auf die mittlere Schicht 11 aufgebracht. Auf die obere Schicht 12 wurde eine erste Elektrode 3 aus Pt und auf letzterer eine piezoelektrische Schicht 4 aus PbZr_{0.35}Ti_{0.65}O₃ abgeschieden. Eine zweite Elektrode 5 aus Pt/Ti wurde auf der piezoelektrischen Schicht 4 aufgebracht. Das gesamte Bauelement wurde mit einer Schutzschicht aus SiO₂ versehen. Außerdem wurden an gegenüberliegenden Seiten des Bauteiles Cr/Cu, Ni/Sn SMD-Endkontakte als Stromzuführungen befestigt.

### Ausführungsbeispiel 4

Zur Herstellung eines Volumenwellen-Resonators wurde auf einer Substratschicht 13 aus Si mit einer Passivierungsschicht aus SiO₂ eine Resonatoreinheit aus erster Elektrode 3, piezoelektrischer Schicht 4 und zweiter Elektrode 5 aufgebracht. Die erste Elektrode 3 enthielt Ti/Pt, während die zweite Elektrode 5 aus Pt war. Die piezoelektrische Schicht 4 enthielt AlN. Im nächsten Schritt wurde auf der zweiten Elektrode 5 als Reflexionselement 2 eine Schicht aus porösem SiO₂ aufgebracht. Auf diesem Reflexionselement 2 wurde ein Trägersubstrat 1 aus Glas mit Acrylat-Klebstoff befestigt. Anschließend wurde die Si-Schicht der Substratschicht 13 weggeätzt. In die verbliebene SiO₂-Schicht wurden Kontaktlöcher zur Kontaktierung der ersten Elekrode 3 geätzt. Anschließend wurden Bump-end-Kontakte aus Cr/Cu in den Kontaktlöchern aufgewachsen.

### Ausführungsbeispiel 5

Zur Herstellung eines Volumenwellen-Resonators wurde auf einem Substrat 13 aus Si mit einer Passivierungsschicht aus SiO₂ eine Resonatoreinheit aus erster Elektrode 3, piezoelektrischer Schicht 4 und zweiter Elektrode 5 aufgebracht. Die erste Elektrode 3 enthielt Ti/Pt, während die zweite Elektrode 5 aus Pt war. Die piezoelektrische Schicht 4 enthielt PbZr_{0.35}Ti_{0.65}O₃. Im nächsten Schritt wurde auf der zweiten Elektrode 5 als Reflexionselement 2 eine Schicht aus porösem SiO₂ aufgebracht. Auf diesem Reflexionselement 2 wurde ein Trägersubstrat 1 aus Glas mit Acrylat-Klebstoff befestigt. Anschließend wurde die Si-Schicht des Substrats 13 weggeätzt. In die verbliebene Schicht aus SiO₂ wurden Kontaktlöcher zur Kontaktierung der ersten Elektrode 3 geätzt. Anschließend wurden Bump-end-Kontakte aus Cr/Cu in den Kontaktlöchern aufgewachsen.

### Ausführungsbeispiel 6

Zur Herstellung eines Volumenwellen-Resonators wurde auf einem Substrat 13 aus Si mit einer Passivierungsschicht aus SiO₂, eine Resonatoreinheit aus einer ersten Elektrode 3, einer piezoelektrischen Schicht 4 und einer zweiten Elektrode 5 aufgebracht. Die erste Elektrode 3 enthielt Ti/Pt und die zweite Elektorde 5 enthielt Pt. Die piezoelektrische Schicht 4 enthielt PbZr_{0.15}Ti_{0.85}O₃ und wurde mittels Schleuderverfahren hergestellt. Im nächsten Schritt wurde auf die zweite Elektrode 5 eine 30 nm dicke Schicht aus SiO₂, ein Reflexionselement 2 aus porösem SiO₂ und eine 300 nm dicke Schicht aus SiO₂ aufgebracht. Auf diesen Aufbau wurde ein Trägersubstrat 1 aus Glas mit einem Acrylat-Klebstoff befestigt. Anschließend wurde die Si-Schicht des Substrats 13 weggeätzt. In die verbliebene Schicht aus SiO₂ wurden Kontaktlöcher zur Kontaktierung der ersten Elektrode 3 geätzt. Anschließend wurden Bump-end Kontakte aus Cr/Cu in den Kontaktlöchern aufgewachsen.

### Ausführungsbeispiel 7

Zur Herstellung eines Volumenwellen-Resonators wurde auf einem Substrate 13 aus Si mit einer Passivierungsschicht aus SiO₂, eine Resonatoreinheit aus einer ersten Elektrode 3, einer piezoelektrischen Schicht 4 und einer zweiten Elektrode 5 aufgebracht. Die erste Elektrode 3 enthielt Ti/Pt und die zweite Elektorde 5 enthielt W_{0.9}Ti_{0.1}/Al(Cu). Die piezoelektrische Schicht 4 enthielt PbZr_{0.35}Ti_{0.65}O₃. und wurde mittels Schleuderverfahren hergestellt. Im nächsten Schritt wurde auf die zweite Elektrode 5 eine 30 nm dicke Schicht aus SiO₂, ein Reflexionselement 2 aus porösem SiO₂ und eine 300 nm dicke Schicht aus SiO₂ aufgebracht. Auf diesen Aufbau wurde ein Trägersubstrat 1 aus Glas mit einem Acrylat-Klebstoff befestigt. Anschließend wurde die Si-Schicht des Substrats 13 weggeätzt. In die verbliebene Schicht aus SiO₂ wurden Kontaktlöcher zur Kontaktierung der ersten Elektrode 3 geätzt. Anschließend wurden Bump-end Kontakte aus Cr/Cu in den Kontaktlöchern aufgewachsen.

### Ausführungsbeispiel 8

Zur Herstellung eines Volumenwellen-Resonators wurde auf einem Substrate 11 aus Si mit einer Passivierungsschicht aus SiO₂, eine Resonatoreinheit aus einer ersten Elektrode 3, einer piezoelektrischen Schicht 4 und einer zweiten Elektrode 5 aufgebracht. Die erste und zweiter Elektrode enthielten jeweils Ti/Pt. Die piezoelektrische Schicht 4 enthielt eine PLZT Schicht mit der Zusammensetzung PbZr₀ ₁₅Ti₀ ₈₅O₃ mit 2% Lanthandotierung. Im nächsten Schritt wurde auf die zweite Elektrode 5 eine 30 nm dicke Schicht aus SiO₂, ein Reflexionselement 2 aus porösem SiO₂ und eine 300 nm dicke Schicht aus SiO₂ aufgebracht. Auf diesen Aufbau wurde ein Trägersubstrat 1 aus Glas mit einem Acrylat-Klebstoff befestigt. Anschließend wurde die Si-Schicht des Substrats 13 weggeätzt. In verbliebene Schicht aus SiO₂ wurden Kontaktlöcher zur Kontaktierung der ersten Elektrode 3 geätzt. Anschließend wurden Bump-end Kontakte aus Cr/Cu in den Kontaktlöchern aufgewachsen.

## Patentansprüche

1. Filteranordnung mit einem Trägersubstrat (1), einer Resonatoreinheit und einem Reflexionselement (2) zwischen Trägersubstrat (1) und Resonatoreinheit,
dadurch gekennzeichnet,
daß das Reflexionselement (2) eine Schicht aus einem Schallreflexionsstoff enthält.

2. Filteranordnung nach Anspruch 1,
dadurch gekennzeichnet,
daß der Schallreflexionsstoff aus der Gruppe der polymeren und porösen Stoffe ist.

3. Filteranordnung nach Anspruch 1,
dadurch gekennzeichnet,
daß der Schallreflexionsstoff ein Aerogel, ein Xerogel, ein Glasschaum, ein schaumartiger Klebstoff, ein Schaumstoff oder ein Kunststoff mit geringer Dichte ist.

4. Filteranordnung nach Anspruch 1,
dadurch gekennzeichnet,
daß das Reflexionselement (2) Schichten (10,11,12) mit abwechselnd hoher und niedriger Impedanz und als Material für eine Schicht (10,12) mit niedriger Impedanz einen Schallreflexionsstoff aufweist.

5. Filteranordnung nach Anspruch 3,
dadurch gekennzeichnet,
daß das Material mit hoher Impedanz HfO₂, Mo, Au, Ni, Cu, W, Ti/W/Ti, WₓTi₁₋ₓ (0 ≤ x ≤ 1), Diamant, Ta₂O₅, Pt, Ti/Pt oder einen Kunststoff mit hoher Dichte enthält.

6. Filteranordnung nach Anspruch 3,
dadurch gekennzeichnet,
daß die Dicke der Schichten (10,11,12) jeweils ein Viertel der Resonanzwellenlange ist.

7. Filteranordnung nach Anspruch 1,
dadurch gekennzeichnet,
daß ein weiteres Reflexionselement (6) auf der Resonatoreinheit angeordnet ist.

8. Filteranordnung nach Anspruch 1,
dadurch gekennzeichnet,
daß über der Filteranordnung eine Schutzschicht (7) aus einem organischen und/oder anorganischen Material ist.

9. Filteranordnung nach Anspruch 1,
dadurch gekennzeichnet,
daß das Trägersubstrat (1) ein keramisches Material, ein keramisches Material mit einer Planarisierungsschicht aus Glas, ein glaskeramisches Material, ein Glasmaterial, Silicium, GaAs oder Saphir enthält.

10. Filteranordnung nach Anspruch 1,
dadurch gekennzeichnet,
daß die Resonatoreinheit eine piezoelektrische Schicht (4) aus PbZr_{0.15}Ti_{0.85}O₃ mit einer 2%igen Lanthan-Dotierung enthält.

11. Filteranordnung nach Anspruch 1,
dadurch gekennzeichnet,
daß ober- und/oder unterhalb eines Reflexionselementes (2,6) eine Schicht aus SiO₂ ist.

12. Filteranordnung nach Anspruch 1,
dadurch gekennzeichnet,
daß zwischen Trägersubstrat (1) und Reflexionselement (2) eine Klebstoffschicht ist.

13. Mobilfunkgerät ausgerüstet mit einer Filteranordnung mit einem Trägersubstrat (1), einer Resonatoreinheit und einem Reflexionselement (2) zwischen Trägersubstrat (1) und Resonatoreinheit,
dadurch gekennzeichnet,
daß das Reflexionselemnt (2) eine Schicht aus einem Schallreflexionsstoff enthält.

14. Sender ausgerüstet mit einer Filteranordnung mit einem Trägersubstrat (1), einer Resonatoreinheit und einem Reflexionselement (2) zwischen Trägersubstrat (1) und Resonatoreinheit,
dadurch gekennzeichnet,
daß das Reflexionselement (2) eine Schicht aus einem Schallreflexionsstoff enthält.

15. Empfänger ausgerüstet mit einer Filteranordnung mit einem Trägersubstrat (1), einer Resonatoreinheit und einem Reflexionselement (2) zwischen Trägersubstrat (1) und Resonatoreinheit,
dadurch gekennzeichnet,
daß das Reflexionselement (2) eine Schicht aus einem Schallreflexionsstoff enthält.

16. Drahtloses Datenübertragungssystem ausgerüstet mit einer Filteranordnung mit einem Trägersubstrat (1), einer Resonatoreinheit und einem Reflexionselement (2) zwischen Trägersubstrat (1) und Resonatoreinheit,
dadurch gekennzeichnet,
daß das Reflexionselement (2) eine Schicht aus einem Schallreflexionsstoff enthält.

17. Elektronisches Bauelement mit einem Trägersubstrat (1), einer Resonatoreinheit und einem Reflexionselement (2) zwischen Trägersubstrat (1) und Resonatoreinheit,
dadurch gekennzeichnet,
daß das Reflexionselement (2) eine Schicht aus einem Schallreflexionsstoff enthält.

18. Verfahren zur Herstellung eines elektronischen Bauelementes mit einem Trägersubstrat (1), einer Resonatoreinheit und einem Reflexionselement (2) aus einem Schallreflexionsstoff, bei dem
- auf einer Substratschicht (13) eine Resonatoreinheit aufgebracht wird,
- auf der Resonatoreinheit ein Reflexionselement (2) aus einem Schallreflexionsstoff aufgebracht wird,
- auf dem Reflexionselement (2) ein Trägersubstrat (1) befestigt wird und die Substratschicht (13) entfernt wird.
